Europäisches Patentamt

(19) European Patent Office

Office européen des brevets

(11) Numéro de publication: **0 087 994**
**A1**

# (12) DEMANDE DE BREVET EUROPEEN

(21) Numéro de dépôt: 83400309.7

(22) Date de dépôt: 14.02.83

(51) Int. Cl.³: **H 03 K 4/02**
**G 06 F 1/02**

(30) Priorité: 23.02.82 BE 207388

(43) Date de publication de la demande:
07.09.83 Bulletin 83/36

(84) Etats contractants désignés:
DE GB SE

(71) Demandeur: INTERCONTROLE Société Anonyme
15, rue des Solets Zone Silic 433
F-94583 Rungis Cedex(FR)

(72) Inventeur: D'Hont, Jean Pierre
5 Chaussée de Lille
B-7500 Tournai(BE)

(74) Mandataire: Mongrédien, André et al,
c/o BREVATOME 25, rue de Ponthieu
F-75008 Paris(FR)

(54) Générateur numérique programmable.

(57) Le générateur numérique programmable est caractérisé en ce qu'il comprend un circuit générateur d'impulsions d'horloge de fréquence réglable (50), un compteur (46) précédé d'un circuit de préchargement (54) à un contenu initial programmable, une mémoire (40) du type à accès direct (RAM), un convertisseur numérique-analogique (44) suivi d'un amplificateur à gain réglable (57), et en ce qu'il comprend un microprocesseur (60) commandant les organes aptes à être programmés, à savoir le circuit générateur d'impulsions d'horloge (50), le circuit de préchargement (54), le compteur (46), la mémoire (40) et l'amplificateur (57).

Application aux générateurs utilisés dans les appareils de contrôle per courants de Foucault.

FIG. 1

EP 0 087 994 A1

La présente invention a pour objet un générateur numérique programmable. Elle trouve une application dans la réalisation de générateurs de tension, notamment sinusoïdale, destinés en particulier aux appareils de contrôle par courants de Foucault.

Un générateur numérique de tension est constitué par une mémoire dans laquelle sont stockés des échantillons numériques, cette mémoire étant adressée par un compteur et suivie d'un convertisseur numérique-analogique. Le contenu de compteur constitue l'adresse de l'échantillon à lire dans la mémoire. Une horloge commande le compteur qui voit son contenu varier périodiquement de 0 à N-1 (si N est sa capacité). N échantillons numériques se succèdent alors à la sortie de la mémoire et sont ensuite transformés en N valeurs analogiques par le convertisseur. Après N coups d'horloge, le compteur est remis à zéro et le cycle recommence.

L'inconvénient de ces dispositifs est leur manque de souplesse qui tient à la prédétermination de leurs caractéristiques. En effet, les mémoires utilisées sont toujours des mémoires mortes, qui ne peuvent être que lues et dont le contenu est immuable. En d'autres termes, il s'agit de mémoires du type "ROM" (pour "Read Only Memory"). Il est alors impossible de modifier la forme de l'onde engendrée et il faut autant de mémoires que de types de signaux désirés. Par ailleurs, pour une mémoire donnée, la fréquence, la phase et l'amplitude du signal délivré sont fixes : la fréquence est déterminée par l'horloge qui commande le compteur, la phase par l'instant où le contenu du compteur passe par zéro et l'amplitude par les caractéristiques du convertisseur numérique-analogique.

La présente invention a justement pour but de remédier à ces inconvénients en proposant un générateur dans lequel la forme de l'onde délivrée, sa fréquence, sa phase et son amplitude sont réglables à volonté, autrement dit sont programmables. Ce but est atteint, d'une part, par l'utilisation d'une mémoire qui n'est plus une mémoire morte mais une mémoire vive à accès direct (en terminologie anglosaxonne "Random Acces Memory" ou RAM en abrégé) et d'autre part, par l'utilisation d'éléments aptes à être programmés. Le générateur de l'invention comprend aussi un microprocesseur qui commande l'ensemble de ces organes selon les tâches à accomplir et selon les caractéristiques à obtenir.

Par ailleurs, la structure du générateur de l'invention autorise l'emploi de composants à hautes performances, notamment à grande rapidité.

De façon précise, l'invention a pour objet un générateur numérique programmable du genre de ceux qui comprennent un circuit générateur d'impulsions d'horloge, un compteur relié à ce circuit, une mémoire comprenant des échantillons numériques d'un signal, cette mémoire possédant une entrée d'adressage reliée au compteur et un convertisseur numérique-analogique relié à la mémoire ; ce générateur est caractérisé en ce que :

- le circuit générateur d'impulsions d'horloge comprend un oscillateur à fréquence fixe suivi d'un diviseur programmable commandant un oscillateur à boucle de phase asservie,
- le compteur est précédé d'un circuit de préchargement à un contenu initial programmable,
- le compteur peut être programmé et rendu transparent,
- la mémoire est du type à accès direct (RAM),

B 7425   RS

- le convertisseur numérique-analogique est suivi d'un amplificateur à gain réglable,

et en ce qu'il comprend un microprocesseur commandant les organes programmables, à savoir le diviseur, le circuit de préchargement, le compteur, la mémoire et l'amplificateur.

Les caractéristiques de l'invention apparaîtront mieux après la description qui suit, d'exemples de réalisation donnés à titre explicatif et nullement limitatif. Cette description se réfère à des dessins annexés sur lesquels :

- la figure 1 est un schéma général d'un générateur selon l'invention,

- la figure 2 illustre un mode particulier de réalisation d'un circuit générateur d'impulsions,

- la figure 3 illustre un mode particulier de réalisation d'un compteur et d'une mémoire,

- la figure 4 illustre un mode particulier de réalisation d'un convertisseur numérique-analogique suivi d'un amplificateur à gain programmable.

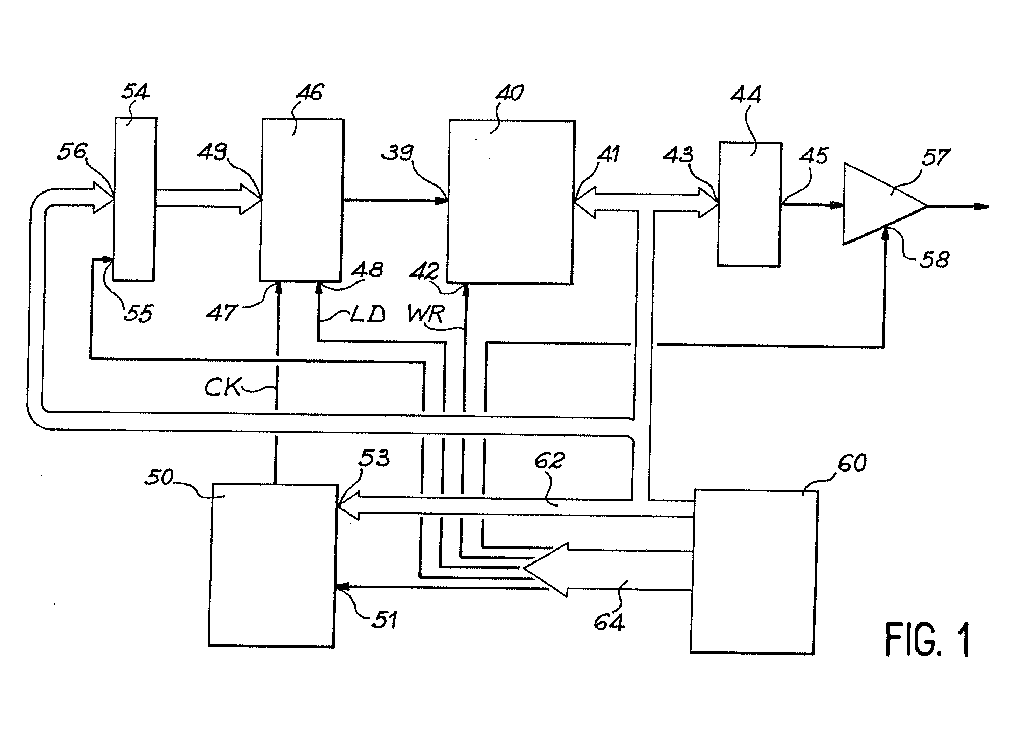

Le générateur représenté sur la figure 1 comprend : une mémoire vive 40 à accès direct (RAM), à une entrée d'adressage 39, un accès d'écriture-lecture 41 et une entrée de commande 42 ; un convertisseur numérique-analogique 44, à une entrée 43 reliée à la sortie 41 de la mémoire et à une sortie 45 ; un compteur 46, à une entrée d'horloge 47, une entrée de commande 48 et une entrée de chargement 49 ; un circuit 50 délivrant, par une connexion CK, des impulsions d'horloge appliquées sur l'entrée 47 du compteur, ce circuit 50 possédant une entrée de commande 51 et une entrée de données 53 ; un circuit 54 de préchargement du compteur 46, possédant une entrée de commande 55 et une entrée de données 56 ; un amplificateur 57 à gain réglable à une entrée de commande

B 7425    RS

58 ; enfin un microprocesseur 60 relié, d'une part, à un bus de données 62 connecté à l'accès 41 de la mémoire, à l'entrée 56 du circuit de préchargement et à l'entrée 53 du circuit 50 et d'autre part, à un bus de commande 64 relié à tous les organes susceptibles d'être programmés, à savoir la mémoire 40 (entrée 42), le compteur 46 (entrée 48), le circuit de préchargement 54 (entrée 55), le générateur 50 (entrée 51), l'amplificateur 57 (entrée 58).

Le fonctionnement de ce circuit est le suivant.

Le balayage de la mémoire 40 s'effectue à un rythme qui est fixé par la fréquence des impulsions délivrées par le circuit 50, véhiculées par la connexion CK et appliquées à l'entrée 47 du compteur 46. La fréquence du signal délivré par le générateur est donc déterminée par le circuit 50.

La phase du signal délivré par le générateur est déterminée par l'instant où le contenu du compteur 46 passe par zéro. Le chargement de ce compteur à un contenu initial permet de régler cette phase. Ce réglage s'effectue donc par l'intermédiaire du circuit de chargement 54.

Quant à l'amplitude, elle est réglée au moyen de l'amplificateur 57 dont le gain peut être commandé à toute valeur appropriée.

Tous ces réglages sont commandés par le microprocesseur 60.

On observera que la mémoire étant de type RAM, elle peut être non seulement lue mais encore écrite. Les échantillons inscrits dans la mémoire peuvent donc, à tout moment, être lus, contrôlés ou modifiés par le microprocesseur 60, ce qui permet de modifier la forme du signal délivré par le générateur.

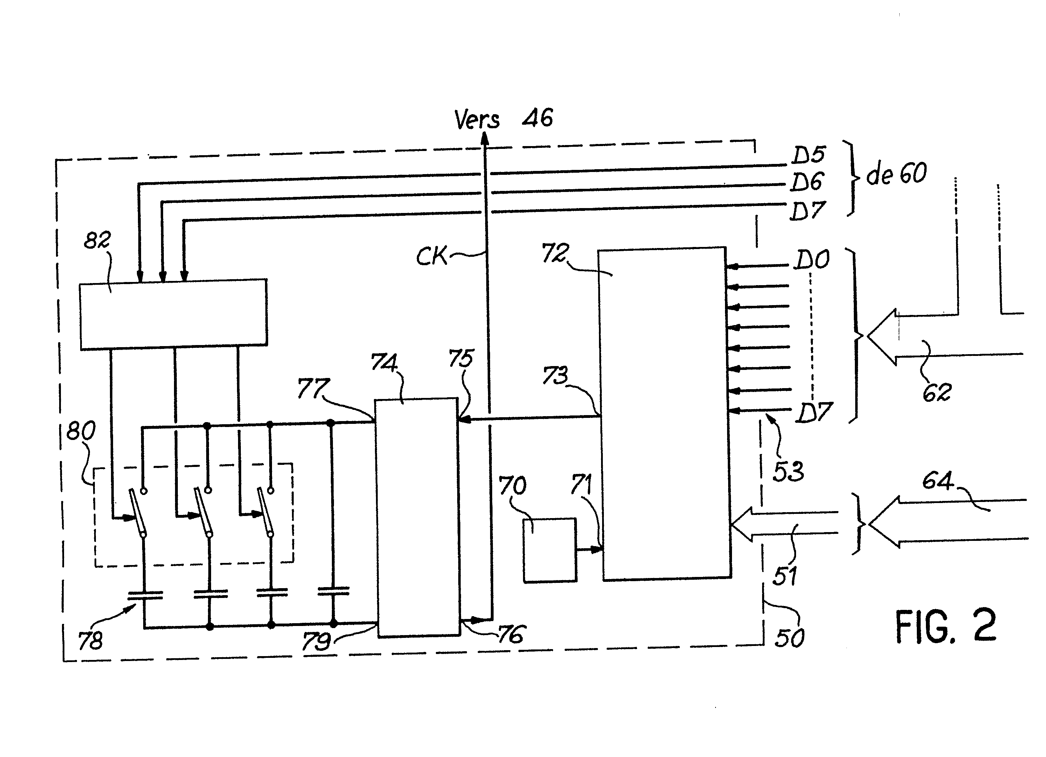

Les circuits illustrés sur les figures 2 à 4 feront mieux comprendre le fonctionnement des moyens utilisés. Les exemples pris correspondent au cas où la mémoire travaille avec 512 échantillons de 12 éléments binaires (ou bits), la fréquence étant réglable de 3 à 3000 Hz par pas de 1Hz et la phase de 0 à $2\pi$ par pas de $2\pi/512$.

La figure 2 tout d'abord représente le circuit 50 qui engendre les impulsions d'horloge. Ce circuit comprend : une horloge à quartz 70 à très haute stabilité ; un circuit diviseur 72, qui reçoit les impulsions de l'horloge sur une entrée 71 et réémet, par une sortie 73, des impulsions à une fréquence qui est un sous-multiple de celle de l'oscillateur 70 ; un oscillateur 74, du type à boucle de phase asservie, qui reçoit sur une entrée 75 les impulsions émises par le diviseur et qui constituent une référence de fréquence et qui délivre sur une sortie 76 des impulsions à la fréquence désirée.

On sait qu'un tel oscillateur, appelé en terminologie anglosaxonne "Phase-locking-loop" ou "PLL", comprend un oscillateur commandé en tension (VCO), un comparateur de phase recevant l'onde émise par cet oscillateur et une onde de référence (en l'occurrence l'onde appliquée sur l'entrée 75), ce comparateur délivrant un signal d'erreur qui est fonction de l'écart de phase entre l'onde de référence et l'onde engendrée par l'oscillateur VCO, ce signal d'erreur étant réappliqué à l'oscillateur commandé en tension. Par ailleurs, si, entre la sortie de l'oscillateur VCO, et l'entrée du comparateur de phase, est disposé un diviseur de fréquence, la fréquence délivrée par le circuit peut être un multiple de la fréquence de référence, le multiple étant précisément le facteur de division du diviseur. De tels circuits sont bien connus et ne sont donc pas illustrés. Il peut s'agir par exemple du circuit CD 4046 de la firme RCA.

Le circuit représenté sur la figure 2 comprend encore une batterie de condensateurs 78 disposée entre deux accès 77 et 79 du circuit 74, ces condensateurs servant à prérégler la fréquence de l'oscillateur VCO dans la gamme contenant la fréquence désirée. Ces condensateurs sont mis en circuit au moyen d'un jeu d'interrupteurs 80 commandés par un circuit 82 qui est du type "verrou" ("latch" en terminologie anglosaxonne). Ce circuit reçoit du microprocesseur 60 des données aptes à déterminer lequel de ces interrupteurs doit être fermé pour mettre en circuit le condensateur approprié.

En définitive, les impulsions véhiculées par la connexion CK constituent les impulsions de commande du compteur 46. Leur fréquence est réglable par action sur le diviseur 72. Cette action est rendue possible par l'entrée 53 reliée au bus de données 62 provenant du microprocesseur. Ces données sont à 8 bits et sont véhiculées par 8 connexions D0, D1,...D7. Par ailleurs, le circuit 72 reçoit des signaux de commande par son entrée 51 à travers le bus de commande 64.

Pour fonctionner à une fréquence f avec une mémoire de 512 échantillons, le circuit 50 devra fournir 512f impulsions par seconde. Si F désigne la fréquence de l'oscillateur à quartz 70, le facteur de division du circuit 72 devra être égal à F/512f. Une première division par 512 peut être effectuée, puis une division par la fréquence f désirée.

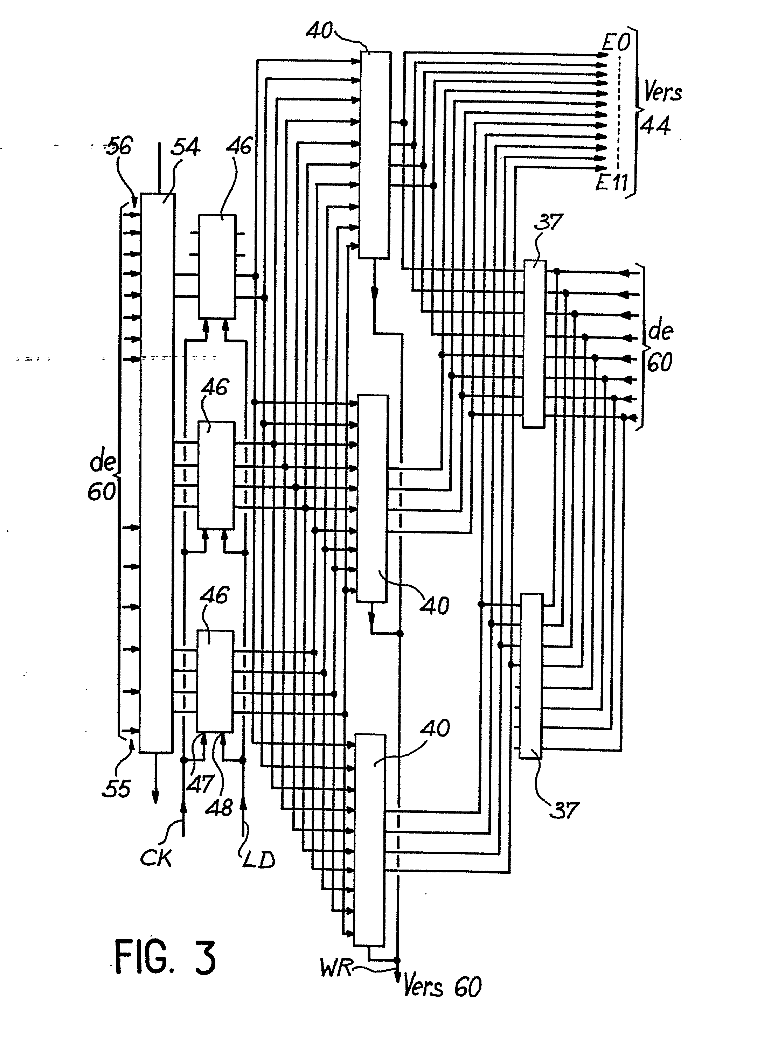

La figure 3 représente la mémoire 40 formée en l'occurrence de trois circuits 2148H, avec sa connexion d'écriture-lecture WR, ses entrées-sorties

B 7425   RS

sur la droite et ses entrées d'adressage sur la gauche. Ces dernières sont reliées au compteur 46 formé de trois circuits 74LS191, lesquels possèdent une entrée d'horloge 47 reliée à la connexion CK et une entrée de commande 48 reliée à la connexion LD commandant le chargement. Ce compteur est relié au circuit de préchargement 54, qui est un circuit interface, par exemple de type 8255. Ce circuit reçoit sur ses entrées 56 les données fixant le contenu initial à charger. Une entrée 55 permet de commander ce chargement.

L'écriture et la lecture dans la mémoire 40 s'effectuent, de la part du microprocesseur, à travers un circuit tampon bidirectionnel 37 formé de deux circuits 8304.

Le compteur 46 est programmable en ce sens que ces sorties peuvent être bloquées sur un contenu particulier, ce contenu étant chargé par le circuit 54, ce qui revient à dire que le compteur devient transparent.

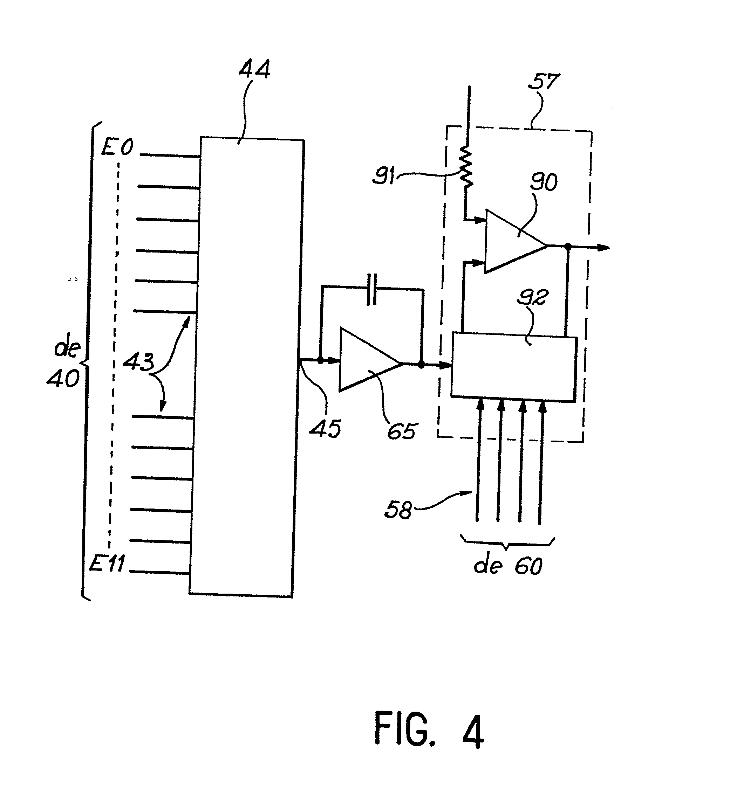

Les 12 bits des échantillons lus dans la mémoire sont adressés au convertisseur numérique-analogique 44 par 12 connexions EO à E11. La figure 4 représente ce convertisseur qui reçoit sur son entrée 43 ces 12 bits et qui délivre, sur sa sortie 45, un signal analogique. Ce convertisseur peut être du type AD565. Dans ce cas, il délivre un courant. Il doit donc être suivi d'un convertisseur courant-tension 65, lequel est relié à l'amplificateur à gain réglable 57.

Ce dernier circuit comprend un amplificateur 90 à deux entrées, l'une reliée à une résistance fixe 91, l'autre à une résistance 92 programmable depuis le microprocesseur. Le gain de l'amplificateur est alors réglable par action sur la résistance 92.

B 7425    RS

Le circuit 90 peut être du type AD544 et le circuit
92 du type AD7542. Ce dernier possède alors des entrées de commande 58 reliées au microprocesseur 60.

REVENDICATION

1. Générateur numérique programmable comprenant un circuit (50) générateur d'impulsions d'horloge, un compteur (46) relié à ce circuit, une mémoire (40) comprenant des échantillons numériques d'un signal, cette mémoire possédant une entrée d'adressage (39) reliée au compteur, un convertisseur numérique-analogique (44) relié à la mémoire, caractérisé en ce que :

- le circuit générateur d'impulsions d'horloge comprend un oscillateur à fréquence fixe (70) suivi d'un diviseur programmable (72) commandant un oscillateur (74) à boucle de phase asservie,

- le compteur (46) est précédé d'un circuit (54) de préchargement à un contenu initial programmable,

- le compteur (46) peut être programmé et rendu transparent,

- la mémoire est du type à accès direct (RAM),

- le convertisseur numérique-analogique est suivi d'un amplificateur à gain réglable (57),

et en ce qu'il comprend un microprocesseur (60) commandant les organes aptes à être programmés, à savoir le diviseur (72), le circuit de préchargement (54), le compteur (46), la mémoire (40) et l'amplificateur (57).

FIG. 1

Vers 46

FIG. 2

2/4

0087994

3/4

0087994

FIG. 3

FIG. 4

Office européen
des brevets

**RAPPORT DE RECHERCHE EUROPEENNE**

00**87994**
Numéro de la demande

EP 83 40 0309

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | SIEMENS REVIEW, vol. 45, no. 10, 1978 J.-L. PFEFFER "Computer-controlled waveshape generator for programmable waveschapes" pages 464-467 * Document en entier * | 1 | H 03 K 4/02<br>G 06 F 1/02 |
| A | GB-A-2 010 032 (HONEYWELL INC.) | | |
| A | GB-A-2 036 483 (GENERAL ELECTRIC CO., LTD.) * Figure * | 1 | |
| A | US-A-4 171 466 (BELL TELEPHONE LABORATORIES) | | |
| A | TOUTE L'ELECTRONIQUE, no. 441, mars 1979 K. KUEHNE "La synthèse numérique de signaux" pages 69-71 | | DOMAINES TECHNIQUES RECHERCHES (Int. Cl. 3) |
| A | TOUTE L'ELECTRONIQUE, no. 453, avril 1980 R. MONTORI "Le "microP" dans les appareils de mesure" pages 27-32 | | G 06 F 1/02<br>G 06 G 7/26<br>G 06 G 7/28<br>H 03 K 4/02 |

Le présent rapport de recherche a été établi pour toutes les revendications

| Lieu de la recherche<br>BERLIN | Date d'achèvement de la recherche<br>16-05-1983 | Examinateur<br>ARENDT M |
|---|---|---|